# EUROPEAN PATENT SPECIFICATION

(11) **EP 2 723 149 B1**
(45) Date of publication and mention of the grant of the patent: **29.07.2015**
(21) Application number: 13186352.4
(22) Date of filing: 27.09.2013
(51) Int. Cl.: H05K 5/02, H05K 7/14

(54) **MOUNTING PLATE TO WHICH APPARATUS IS MOUNTED, APPARATUS, AND SYSTEM**
MONTAGEPLATTE, AN DER EINE VORRICHTUNG MONTIERT IST, VORRICHTUNG UND SYSTEM
PLAQUE DE MONTAGE À LAQUELLE UN APPAREIL EST MONTÉ, APPAREIL ET SYSTÈME

(30) Priority: 19.10.2012 JP 2012232143
(43) Date of publication of application: 23.04.2014
(73) Proprietor: OMRON CORPORATION, Kyoto-shi, Kyoto 600-8530 (JP)
(72) Inventor: Akamoto, Keigo, Kyoto-shi, Kyoto 600-8530 (JP); Takashiro, Hiroto, Kyoto-shi, Kyoto 600-8530 (JP); Fujiwara, Yasuhiro, Kyoto-shi, Kyoto 600-8530 (JP); Otaku, Tatsuya, Kyoto-shi, Kyoto 600-8530 (JP)
(74) Representative: Kilian Kilian & Partner

(56) References cited:
- US-A1- 2012 026 660
- US-B1- 6 386 502

## Description

### TECHNICAL FIELD

The present invention relates to a mounting plate to which an apparatus is mounted, an apparatus, and a system.

### BACKGROUND ART

Japanese Unexamined Patent Publication No. 2004-031481 discloses a technology in which an apparatus, such as a power conditioner, is fixed to a wall surface etc. via a mounting plate.

When a latching member for mounting an apparatus to a mounting plate is provided in the back surface of the apparatus, a user cannot check a position of the latching member provided in the apparatus, making it difficult for the user to latch the latching member provided in the apparatus to a mounting plate-side latching member provided in the mounting plate.
A mounting plate to which an apparatus is mounted, according to the preamble of claim 1 is known from US 2012/026660 A1. Further prior art is known from US 6 386 502 B1.

### SUMMARY

In accordance with one aspect of the present invention, there is provided a mounting plate to which an apparatus is mounted, the mounting plate including: a main plate arranged in a position facing a back surface of the apparatus; a side plate arranged in a position facing a side surface of the apparatus; a mounting plate-side latching member provided in the main plate, to which an apparatus-side latching member provided in the back surface of the apparatus is latched; and a mounting plate-side guide structure provided in the side plate and configured to guide the apparatus-side latching member to the mounting plate-side latching member by collaborating with an apparatus-side guide structure provided in the side surface of the apparatus when mounting the apparatus to the mounting plate.

In the mounting plate, one of the apparatus-side guide structure and the mounting plate-side guide structure is a guide pin and the other is a guide hole. In the mounting plate, the guide hole includes a first guide hole configured to guide the apparatus-side latching member in a direction of the main plate, and a second guide hole configured to extend from the first guide hole and guide the apparatus-side latching member in a direction along the main plate. The first guide hole may be formed to extend along a direction perpendicular to the main plate, and the second guide hole may be formed to extend along a direction parallel to the main plate.

The first guide hole may have a tapered shape which becomes narrower toward a first end of the first guide hole which is near the second guide hole from a second end of the first guide hole from which the guide pin is inserted. The apparatus-side guide structure may be the guide pin, the mounting plate-side guide structure may be the guide hole, a bottom surface of the first guide hole may horizontally extend, and a top surface of the first guide hole may incline down from the second end to the first end.

The guide hole may be provided with an entry-limiting portion which restricts movement of the guide pin to the second guide hole from the first guide hole. The entry-limiting portion may have a protrusion formed in a connected portion between the first guide hole and the second guide hole. The mounting plate may further include an eave plate configured to stand up on the main plate.

In accordance with another aspect of the present invention, there is provided an apparatus mounted to a mounting plate which includes a main plate arranged in a position facing a back surface of the apparatus, a side plate arranged in a position facing a side surface of the apparatus, a mounting plate-side latching member provided in the main plate, and a mounting plate-side guide structure provided in the side plate, the apparatus comprising: an apparatus-side latching member provided in the back surface of the apparatus and configured to be latched to the mounting plate-side latching member; and an apparatus-side guide structure provided in the side surface facing the side plate and configured to guide the apparatus-side latching member to the mounting plate-side latching member by collaborating with the mounting plate-side guide structure when the apparatus is mounted to the mounting plate.

The apparatus may further include: a casing; a heat sink configured to radiate heat emitted from the casing; and a fixing plate configured to fix the heat sink in a manner that the heat sink is held between the fixing plate and the casing, in which the fixing plate comprises an opening through which a portion of the heat sink is exposed, the apparatus-side latching member, and the apparatus-side guide structure.

The fixing plate may further include a pillar portion configured to stand up on a back surface side of the apparatus, the apparatus-side latching member may include a latching plate supported by the pillar portion, and the latching plate may be latched to the mounting plate-side latching member. The apparatus-side guide structure may be provided in the pillar portion.

The casing may have an insertion hole formed in the back surface of the apparatus, the insertion hole allowing a cable to be inserted into the apparatus therethrough; and the fixing plate may have an eave plate which configured to stand up to be disposed above the insertion hole.

The summary described above should not be interpreted to enumerate all of the features for the present invention. Subcombinations of feature groups may fall within the scope of the present invention.

### BRIEF DESCRIPTION OF THE DRAWINGS

Fig. 1 is an exploded perspective view of a power conditioner viewed from the back side;
Fig. 2 is an exploded perspective view of the power conditioner viewed from the front side;
Fig. 3 is a perspective view of the power conditioner viewed from the front side;
Fig. 4 is a perspective view of a fixing plate viewed from the front side;
Fig. 5 is a perspective view of the fixing plate from the back side;
Fig. 6 is a perspective view of a mounting plate provided for the power conditioner, which is viewed from the front side;
Fig. 7 is an enlarged perspective view of a guide hole formed in a side surface of the mounting plate;
Fig. 8 is an enlarged perspective view of a guide hole and a guide pin;
Fig. 9 is an enlarged perspective view of a guide hole and a guide pin; and
Fig. 10 is an enlarged perspective view of a recessed portion and a bridge portion viewed from the back side.

### DETAILED DESCRIPTION

Hereinafter, the present invention is described with reference to an embodiment but the embodiment is not intended to limit the invention according to the claims. It should not be construed that all of combinations of the features described in the embodiment are necessarily indispensable to solving means of the invention.

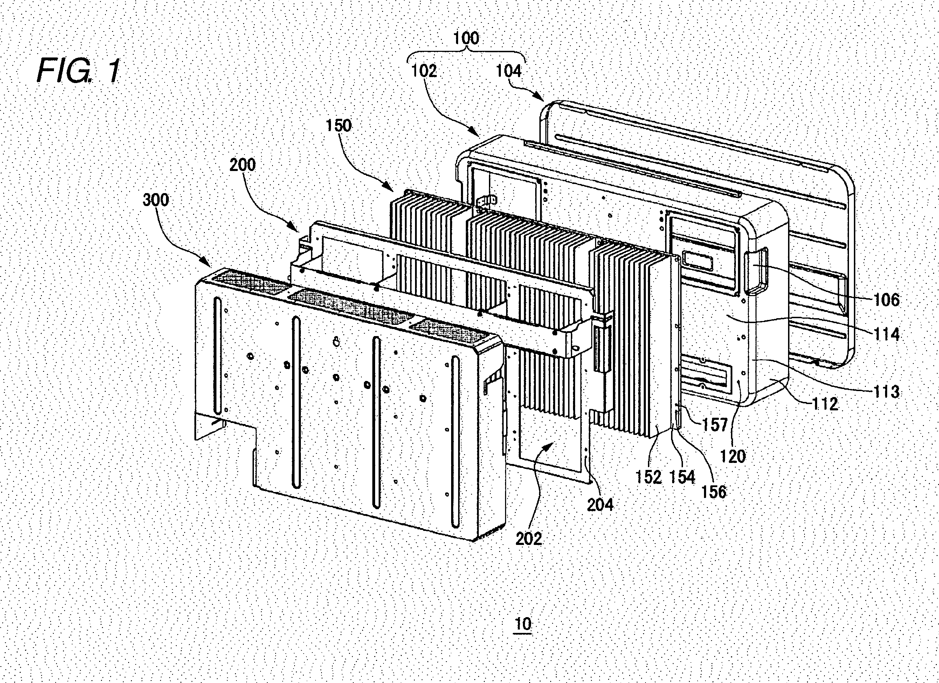

Fig. 1 is an exploded perspective view of a power conditioner 10 viewed from the back side. The power conditioner 10 converts direct current (DC) power supplied from a power source, such as a solar cell or a fuel cell, into alternating current (AC) power. The power conditioner 10 includes a casing 100, a heat sink 150, a fixing plate 200, and a mounting plate 300. The power conditioner 10 is fixed to an outer wall of a housing, etc. via the mounting plate 300. The power conditioner 10 is an example of an apparatus, such as an electronic device or an electrical device.

The casing 100 includes an accommodation box 102 which has an opening formed in a front surface, and a cover 104 which covers the opening of the accommodation box 102. The accommodation box 102 accommodates a first filter circuit, an inverter circuit, and a second filter circuit therein. The first filter circuit reduces noise of the DC power supplied from the power source. The inverter circuit converts the DC power output from the first filter circuit into AC power. The second filter circuit reduces noise of the AC power output from the inverter circuit.

The accommodation box 102 has recessed portions 106 for hand's insertion. Each recessed portion is provided in a corner 113 between a back surface 114 and a side surface 112 adjacent to the back surface 114. The recessed portions 106 for hand's insertion are used when a user carries the power conditioner 10.

The heat sink 150 is provided in the back surface 114 of the accommodation box 102. The heat sink 150 radiates heat generated by a heating element installed in the accommodation box 102. The heating element includes semiconductor devices, such as a switching element and a diode, which constitute the first filter circuit, the inverter circuit, and the second filter circuit. The heat sink 150 includes radiation fin portions 152, each including a plurality of radiation fins, and fixed portions 154 disposed around the radiation fin portions 152.

The heat sink 150 is fixed by the fixing plate 200 in a manner that the heat sink 150 is held between the casing 100 and the fixing plate 200. The fixing plate 200 has an opening 202 through which a portion of the heat sink 150 is exposed. The heat sink 150 is fixed by the fixing plate 200 in a manner that the fixed portion 154 is held between the fixing plate 200 and the casing 100. In a state in which the fixed portion 154 is held between the fixing plate 200 and the casing 100, the radiation fin portion 152 protrudes outward through the opening 202.

The heat sink 150 includes a plurality of through holes 156 formed in the fixed portion 154. The heat sink 150 further includes a plurality of positioning holes 157 which are used to align the heat sink 150 with respect to the fixing plate 200. The casing 100 includes a plurality of through holes 120 in positions corresponding to the plurality of through holes 156, respectively. The fixing plate 200 includes a plurality of female screws 204 in positions corresponding to the plurality of through holes 156 and the plurality of through holes 120. The through holes 156 and the through holes 120 may be plain holes without screw threads, or screw-threaded holes. The heat sink 150 is held between the casing 100 and the fixing plate 200 using screw members which are inserted into the through holes 156 and the through holes 120. More specifically, the heat sink 150 is held between the casing 100 and fixing plate 200 by screwing male screws which are the screw members into female screws 204, i.e., by inserting the screw members into the through holes 120 and through holes 156 from inside of the casing 100.

Here, the fixing plate 200 and the female screw 204 are made from a material harder than the heat sink 150. The fixing plate 200 and the female screw 204 are made from a comparatively hard material, for example, iron and the heat sink 150 is made from a comparatively soft material, for example, aluminum. Therefore, even when vibration or a shock is applied to the power conditioner 10, the fixing plate 200 and the female screws 204 are unlikely to be easily deformed. Since the heat sink 150 is not directly fixed with use of the male screw, even when vibration or a shock is applied to the power conditioner 10, deformation of the heat sink 150 attributable to being contact with the male thread does not occur.

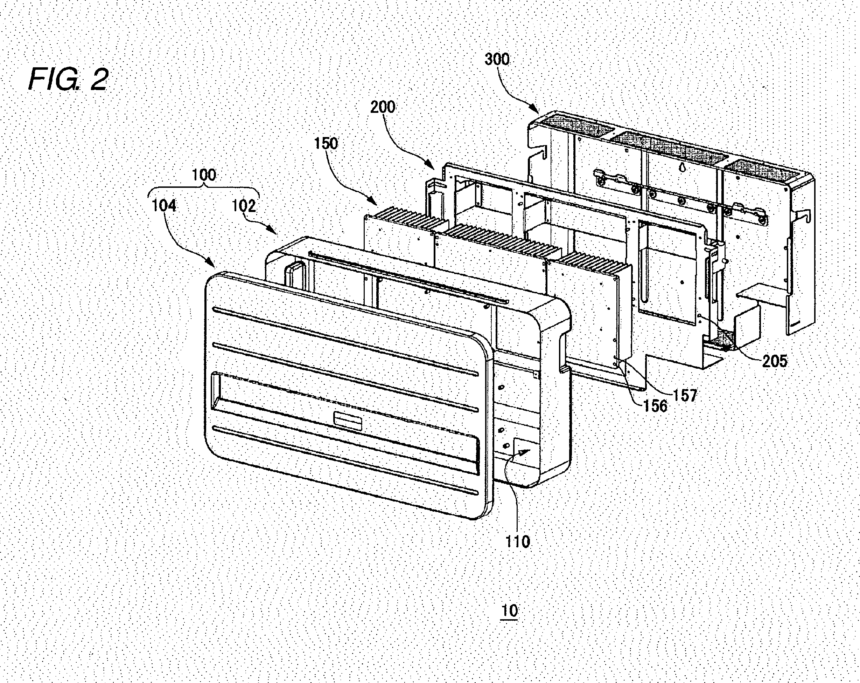

Fig. 2 is an exploded perspective view of a power conditioner 10 according to the present embodiment, which is viewed from the front side. The accommodation box 102 has an insertion hole 110 formed in the back surface, and the insertion hole 110 is used to insert a cable into the accommodation box 102. A plurality of protrusions 205 are formed in positions corresponding to the positioning holes 157 formed in the heat sink 150. The plurality of protrusions 205 are formed in the front surface of the fixing plate 200. With this structure, the heat sink 150 can be accurately aligned with respect to the fixing plate 200. Furthermore, even though vibration or a shock is applied to the power conditioner 10, the force attributable to the vibration or shock and exerted on the positioning holes 157 and the through holes 156 is distributed. Therefore, it is possible to suppress the positioning holes 157 and the through holes 156 from being damaged due to vibration or a shock.

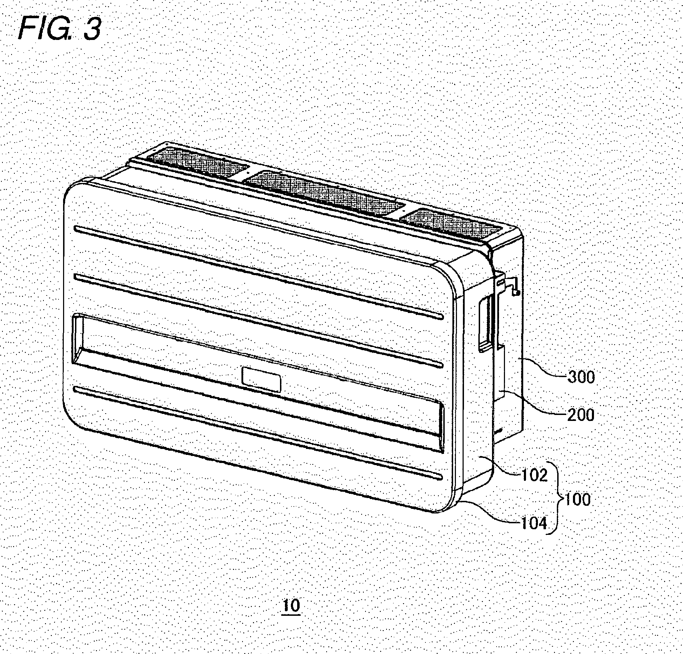

Fig. 3 is a perspective view of the power conditioner 10 viewed from the front side. The fixing plate 200, the heat sink, the accommodation box 102, and the cover 104 are assembled in an arrangement shown in Figs. 1 and 2. The casing 100 which holds the heat sink 150 between itself and the fixing plate 200 is mounted to the mounting plate 300.

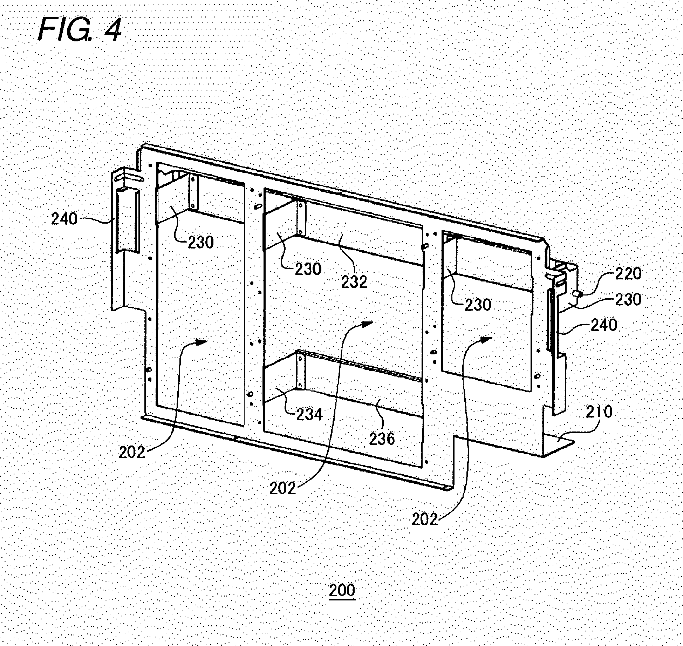

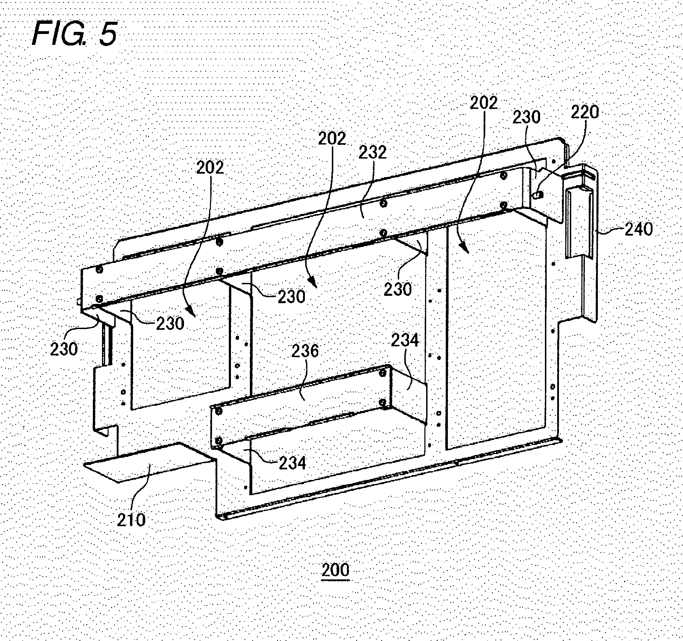

Fig. 4 is a perspective view of the fixing plate 200 provided for the power conditioner 10, which is viewed from the front side. Fig. 5 is a perspective view of the fixing plate 200 viewed from the back side. As illustrated in Figs. 4 and 5, the fixing plate 200 has openings 202 in positions corresponding to the radiation fin portions 152 of the heat sink 150. When the fixing plate 200 is fixed to the back surface of the accommodation box 102, the radiation fin portions 152 are inserted into the openings 202, respectively and thus the radiation fin portions 152 are exposed through the openings 202.

A plurality of pillar portions 230 are formed to protrude from the back surface of the fixing plate 200 on both sides of each opening 202. A latching plate 232 is disposed between the plurality of pillar portions 230. The latching plate 232 is supported by the plurality of pillar portions 230 and fixed to end portions of the plurality of pillar portions 230. The latching plate 232 is latched to a mounting plate-side latching member provided in the mounting plate 300. The power conditioner 10 is mounted to the mounting plate 300 when the latching plate 232 is latched to the mounting plate-side latching member.

Two pillar portions 234 are provided on both sides of a central opening 202 in a manner of protruding from the back surface of the fixing plate 200. A plate 236 which functions as a reinforcing plate for preventing deformation of the fixing plate 200 is fixed to end portions of the two pillar portions 234. The fixing plate 200 further includes a fixing plate-side eave plate 210 arranged above the insertion hole 110 formed in the accommodation box 102.

Guide pins 220 for guiding the latching plate 232 to the mounting plate-side latching member 330 are provided in external surfaces of the pillar portions 230 arranged on both sides of the power conditioner 10 among the plurality of pillar portions 230. The fixing plate 200 includes a bridge portion 240, serving as a strap which extends across the corresponding recessed portion 106 for hand's insertion provided in the accommodation box 102. A user can carry the power conditioner 10 by inserting hands into the recessed portions 106 from the back of the power conditioner 10 and grasping the bridge portions 240.

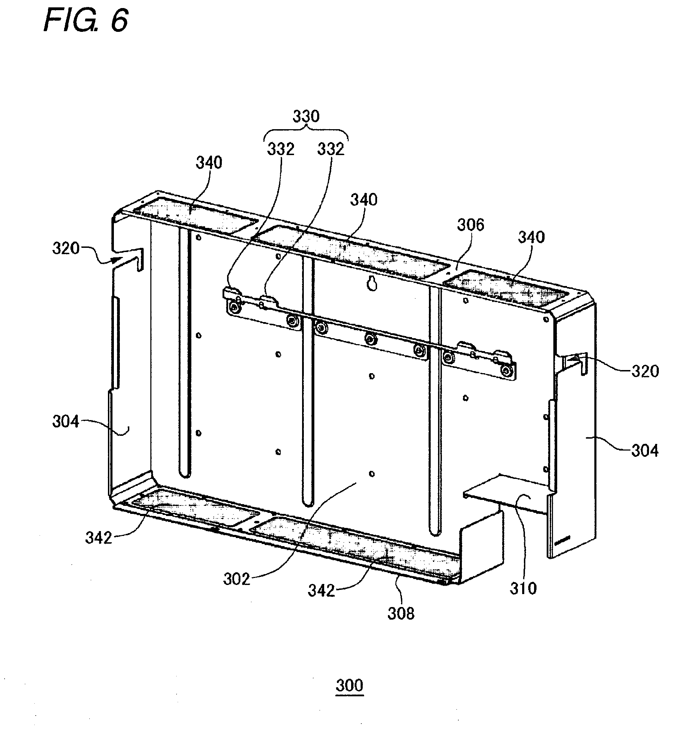

Fig. 6 is a perspective view of the mounting plate 300 of the power conditioner 10 viewed from the front side. The mounting plate 300 includes a main plate 302 to be attached to an outer wall etc. The mounting plate 300 includes side plates 304, a top plate 306, and a bottom plate 308 as sub plates. The main plate 302 is disposed in a position at which the main plate 302 faces the back surface of the power conditioner 10. The side plates 304 are disposed in positions at which the side plates 304 face side surfaces of the power conditioner 10, respectively. The top plate 306 is disposed in a position at which the top plate 306 faces atop surface of the power conditioner 10. The bottom plate 308 is disposed in a position at which the bottom plate 308 faces a bottom surface of the power conditioner 10. The top plate 306 and the bottom plate 308 include mesh portions 340 and 342 of a mesh shape, respectively provided in positions facing the radiation fin portions 152. Because of the provision of the mesh shape, foreign substances cannot reach the radiation fin portions 152.

The mounting plate 300 further includes a mounting plate-side latching member 330 provided in the main plate 302. The latching plate 232 which is an apparatus-side latching member provided in the fixing plate 200 is latched to the mounting plate-side latching member 330. The mounting plate-side latching member 330 includes a plurality of hook portions 332, and the latching plate 232 is latched to the plurality of hook portions 332.

The mounting plate 300 has guide holes 320 serving as a mounting plate-side guide structure provided in the side plates 304. The guide holes 320 guide the apparatus-side latching member to the mounting plate-side latching member 330 by collaborating with apparatus-side guide structures provided in the side surfaces of the power conditioner 10, when the power conditioner 10 is mounted to the mounting plate 300. More specifically, the guide holes 320 guide the latching plate 232 to the mounting plate-side latching member 330 by collaborating with the guide pins 220 provided in the pillar portions 230 of the fixing plate 200. The latching plate 232 is provided in the back surface of the power conditioner 10. Therefore, when attaching the power conditioner 10 to the mounting plate 300, it is difficult for a user to see the latching plate 232. Therefore, it is difficult for a user to latch the latching plate 232 to the mounting plate-side latching member 330. Then, a user can easily mount the power conditioner 10 to the mounting plate 300 as the guide holes 320 and guide pins 220 collaborate to guide the latching plate 232 to the mounting plate-side latching member 330.

The mounting plate 300 further includes a mounting plate-side eave plate 310 arranged above the insertion hole 110 formed in the accommodation box 102. The mounting plate-side eave plate 310 is formed in a position where the fixing plate 200 overlaps the fixing plate-side eave plate 210 when viewed in a vertical direction. The fixing plate-side eave plate 210 and the mounting plate-side eave plate stand up to mutually face each other, and are arranged at positions where they overlap when viewed in the vertical direction.

When the eave plate is provided for only either one of the fixing plate 200 and the mounting plate 300, a gap is likely to be formed between an end of the eave plate and the other plate for which the eave plate is not provided. When such a gap exists, there is a possibility that rain water, which falls through the gap and passes between the radiation fin portions 152 of the heat sink 150, may drop onto the cable installed in the insertion hole 110. The rain water is likely to flow along the cable and invade inside of the casing 100 through the insertion hole 110.

On the other hand, when both of the fixing plate 200 and mounting plate 300 are provided with respective eave plates, even when the gap exists between one eave plate provided for one of both of the plates and the other plate, the other eave plate provided for the other plate prevents the rain water which dropped through the gap from being poured onto the cable. Therefore, with a structure in which the eave plates are provided for both of the fixing plate 200 and the mounting plate 300, it is possible to prevent the rain water from flowing along the cable from the insertion hole 110 and invading inside of the casing 100.

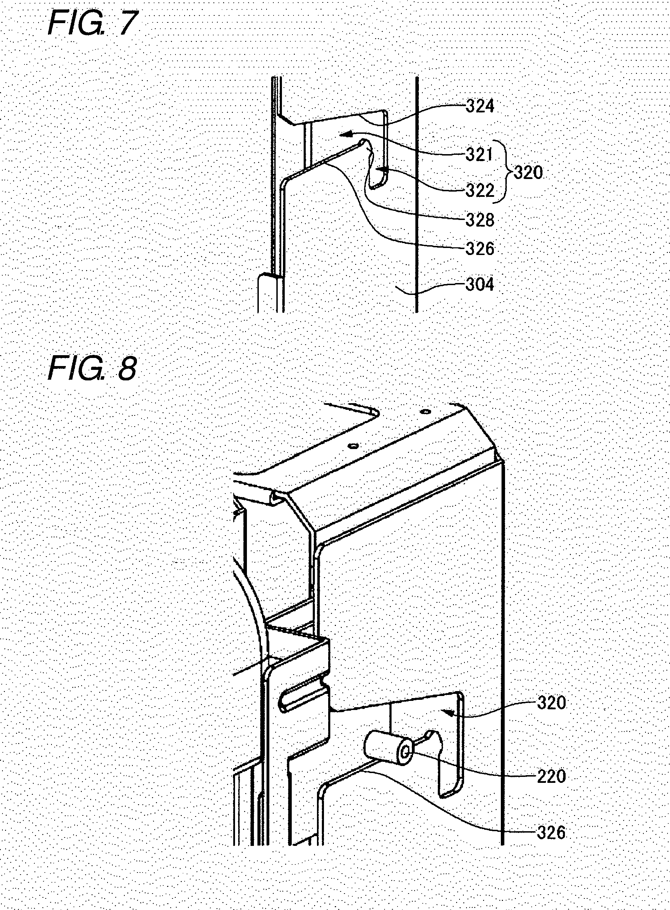

Fig. 7 is an enlarged perspective view of the guide hole 320 formed in the side plate 304 of the mounting plate 300. The guide hole 320 includes a first guide hole 321 and a second guide hole 322. The first guide hole 321 guides the latching plate 232 in the direction of the main plate 302. The second guide hole 322 extends from an end of the first guide hole 321, and guides the latching plate 232 in a direction along the main plate 302. The first guide hole 321 is formed to extend along the direction perpendicular to the main plate 302. The second guide hole 322 is formed to extend along the direction parallel to the main plate 302.

Here, the term "perpendicular" may mean either "perfectly perpendicular" or "substantially perpendicular". The term "substantially perpendicular" means an angle at which an aim of guiding the latching plate 232 in the direction of the main plate 302 can be achieved. The term "parallel" may mean either "perfectly parallel" or "substantially parallel". The term "substantially parallel" means an angle at which an aim of moving the latching plate 232 downward and causing the latching plate 232 to be latched to the plurality of hook portions 332.

The first guide hole 321 is formed in a tapered shape so that it becomes narrower from one end of the first guide hole 321, from which the guide pin 220 is inserted, toward the other end of the first guide hole 321, from which the second guide hole 322 extends. Because of the tapered shape, a user can easily insert the guide pin 220 into the guide hole 320.

A bottom surface 326 of the first guide hole 321 in the vertical direction horizontally extends. A top surface 324 of the first guide hole 321 in the vertical direction obliquely extends so as to be inclined downward from one end to the other end.

Fig. 8 is an enlarged perspective view of the guide hole 320 and the guide pin 220 in the middle of the process of guiding the latching plate 232, which is the apparatus-side latching member, to the mounting plate-side latching member 330. As mentioned above, because of the structure in which the bottom surface 326 horizontally extends, the guide pin 220 is stably supported on the bottom surface 326 in the middle of the process of guiding the latching plate 232 to the mounting plate-side latching member 330. Therefore, the casing 100 can be placed temporarily and stably with respect to the mounting plate 300.

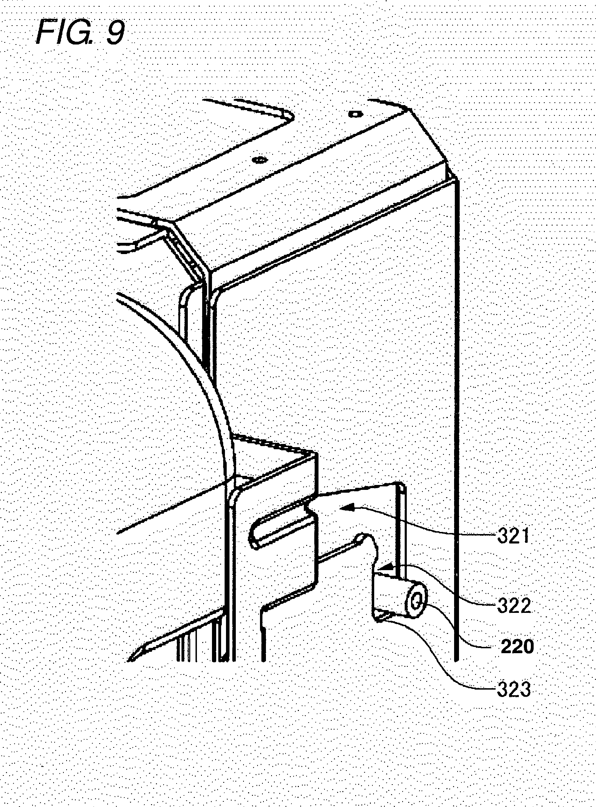

Fig. 9 is an enlarged perspective view of the guide hole 320 and the guide pin 220 in a state in which the latching plate 232 is latched to the mounting plate-side latching member 330. As described above, since the top surface 324 inclines down from one end to the other end, in a state in which the casing 100 is mounted to the mounting plate 300, the pillar portion 230 of the fixing plate 200 can block the guide hole 320 from inside. In the state in which the casing 100 is mounted to the mounting plate 300, the guide pin 220 is not in contact with an end 323 of the second guide hole 322, which is disposed to be opposite to the first guide hole 321. Therefore, the latching plate 232 can be reliably latched to the plurality of hook portions 332.

The term "horizontal" may mean "perfectly horizontal" or "substantially horizontal". The term "substantially horizontal" means an angle at which an aim of temporarily and stably placing the casing 100 with respect to the mounting plate 300 can be achieved.

The guide hole 320 is provided with an entry-limiting portion 328 which restricts movement of the guide pin 220 to the second guide hole 322 from the first guide hole 321. The entry-limiting portion 328 includes a protrusion formed in a bottom surface of a connected portion between the first guide hole 321 and the second guide hole 322. When no entry-limiting portion 328 is provided, a user cannot easily notice that the guide pin 220 enters the connected portion between the first guide hole 321 and the second guide hole 322. When a user cannot notice it and thus when the guide pin 220 progresses from the first guide hole 321 and enters the second guide hole 322, there is a possibility that a user cannot securely hold the casing 100 and thus the casing 100 may fall down in the vertical direction. With the provision of the entry-limiting portion 328, a user can recognize that the guide pin 220 reaches the connected portion between the first guide hole 321 and the second guide hole 322. Therefore, when the guide pin 220 progresses from the first guide hole 321 and enters the second guide hole 322, the user can securely hold the casing 100 and thus it is possible to prevent the casing 100 from falling down in the vertical direction.

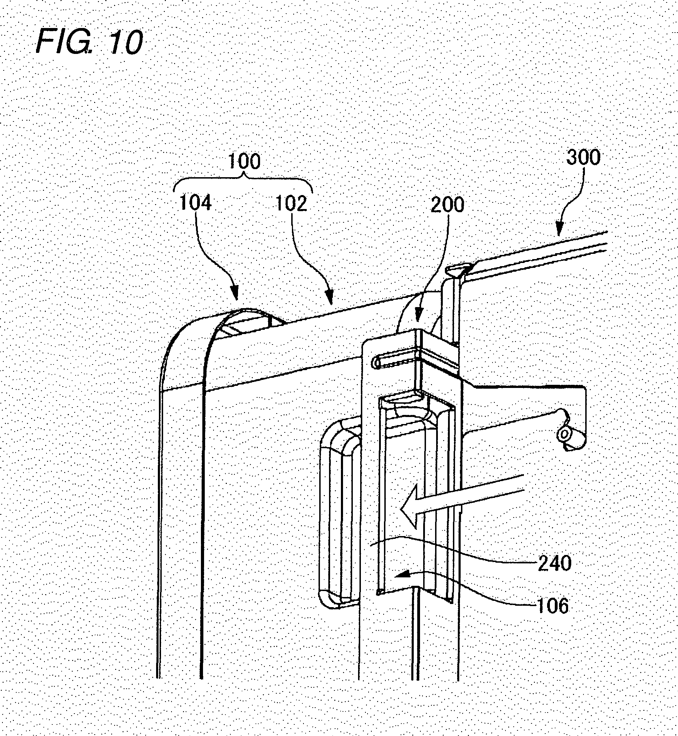

Fig. 10 is an enlarged perspective view of the recessed portion 106 provided in the accommodation box 102 for hand's insertion and the bridge portion 240, serving as a holding strap, provided in the fixing plate 200, which are viewed from the back side. A user can insert hands into the recessed portions 106 in a direction indicated by an arrow illustrated in the drawing and grasp the bridge portion 240. A user can carry the power conditioner 10 more stably compared with a case in which the power conditioner 10 is supported only by the recessed portion 106. Since the fixing plate 200 can be made from a comparatively hard material, such as iron, the casing 100 may not be deformed while the power conditioner 10 is being carried.

In the above embodiment, an example in which the female screw 204 is formed in the fixing plate 200 has been described. However, the female screw may be formed in the casing 100. Alternatively, all of the casing 100, the heat sink 150, and the fixing plate 200 may have female screws. Alternatively, plain through holes without screw threads may be formed in the casing 100, the heat sink 150, and the fixing plate 200, and the heat sink 150 may be held using bolts and nuts. The heat sink 150 may be a radiation plate which does not have the radiation fin portions 152.

In addition, in the above embodiment, an example, in which the fixing plate 200 is provided with the guide pin 220 and the mounting plate 300 is provided with the guide hole 320, has been described. Alternatively, the fixing plate 200 may be provided with the guide hole and the mounting plate 300 may be provided with the guide pin. In such a case, an entrance portion of the first guide hole is formed in the back surface of the fixing plate 200, and the second guide hole extends vertically upward from the first guide hole. And then, the top surface of the first guide hole in the vertical direction may horizontally extend. As for the bottom surface of the first guide hole in the vertical direction, it inclines down from a first end connected to the second guide hole toward a second end (the other end) which the guide pin enters.

In the above embodiment, an example, in which the mounting plate-side latching member 330 has the hook, has been described. However, other structures may be adopted as long as the mounting plate-side latching member 330 and the fixing plate-side latching member are latched to each other in the structure. For example, the latching plate 232 which is the fixing plate-side latching member may have the hook, and the mounting plate-side latching member 330 may have a hole to which the hook is attached.

## Claims

1. A mounting plate (300) to which an apparatus (10) is mounted,
the mounting plate (300) comprising:
a main plate (302) arranged in a position facing a back surface of the apparatus (10);
a side plate (304) arranged in a position facing a side surface of the apparatus (10); and
a mounting plate-side latching member (330) provided in the main plate (302), to which an apparatus-side latching member provided in the back surface of the apparatus (10) is latched; **characterized by**
a mounting plate-side guide structure provided in the side plate (304) and configured to guide the apparatus-side latching member to the mounting plate-side latching member (330) by collaborating with an apparatus-side guide structure provided in the side surface of the apparatus (10) when mounting the apparatus (10) to the mounting plate (300), wherein
one of the apparatus-side guide structure and the mounting plate-side guide structure is a guide pin (220) and the other is a guide hole (320), and
the guide hole (320) includes a first guide hole (321) configured to guide the apparatus-side latching member in a direction of the main plate (302), and a second guide hole (322) configured to extend from the first guide hole (321) and guide the apparatus-side latching member in a direction along the main plate (302).

2. The mounting plate (300) according to claim 1, wherein
the first guide hole (321) is formed to extend along a direction perpendicular to the main plate (302), and the second guide hole (322) is formed to extend along a direction parallel to the main plate (302).

3. The mounting plate (300) according to claim 1 or 2, wherein
the first guide hole (321) has a tapered shape which becomes narrower toward a first end of the first guide hole (321) which is near the second guide hole (322) from a second end of the first guide hole (321) from which the guide pin (220) is inserted.

4. The mounting plate (300) according to claim 3, wherein
the apparatus-side guide structure is the guide pin (220), the mounting plate-side guide structure is the guide hole (321), a bottom surface of the first guide hole (321) horizontally extends, and a top surface of the first guide hole (321) inclines down from the second end to the first end.

5. The mounting plate (300) according to any one of claims 1 to 4, wherein
the guide hole (320) is provided with an entry-limiting portion (328) which restricts movement of the guide pin (220) to the second guide hole (322) from the first guide hole (321).

6. The mounting plate (300) according to claim 5, wherein
the entry-limiting portion (328) has a protrusion formed in a connected portion between the first guide hole (321) and the second guide hole (322).

7. The mounting plate (300) according to any one of claims 1 to 6, further comprising:
an eave plate (310) configured to stand up on the main plate (302).

## Patentansprüche

1. Montageplatte (300), an der eine Vorrichtung (10) angebracht ist,
wobei die Montageplatte (300) folgende Elemente umfasst:
eine Hauptplatte (302), die an einer Position angeordnet ist, die einer Rückseite der Vorrichtung (10) zugewandt ist;
eine Seitenplatte (304), die an einer Position angeordnet ist, die einer Seitenfläche der Vorrichtung (10) zugewandt ist; und
ein montageplattenseitiges Einrastelement (330), das in der Hauptplatte (302) vorgesehen ist und in dem ein vorrichtungsseitiges Einrastelement, das in der Rückseite der Vorrichtung (10) vorgesehen ist, einrastet; **gekennzeichnet durch**
einen montageplattenseitigen Führungsaufbau, der in der Seitenplatte (304) vorgesehen ist und dazu eingerichtet ist, beim Anbringen der Vorrichtung (10) an der Montageplatte (300) das vorrichtungsseitige Einrastelement zum montageplattenseitigen Einrastelement (330) durch Zusammenwirken mit einem vorrichtungsseitigen Führungsaufbau, der in der Seitenfläche der Vorrichtung (10) vorgesehen ist, zu führen, wobei
entweder der vorrichtungsseitige Führungsaufbau oder der montageplattenseitige Führungsaufbau ein Führungsstift (220) ist und der jeweils andere Führungsaufbau eine Führungsöffnung (320) ist, und
die Führungsöffnung (320) eine erste Führungsöffnung (321), die zum Führen des vorrichtungsseitigen Einrastelements in Richtung der Hauptplatte (302) eingerichtet ist, und eine zweite Führungsöffnung (322), die für eine Erstreckung von der ersten Führungsöffnung (321) aus und eine Führung des vorrichtungsseitigen Einrastelements in einer Richtung entlang der Hauptplatte (302) eingerichtet ist, umfasst.

2. Montageplatte (300) nach Anspruch 1, wobei
die erste Führungsöffnung (321) derart ausgebildet ist, dass sie sich entlang einer zu der Hauptplatte (302) senkrechten Richtung erstreckt, und die zweite Führungsöffnung (322) derart ausgebildet ist, dass sie sich entlang einer zu der Hauptplatte (302) parallelen Richtung erstreckt.

3. Montageplatte (300) nach Anspruch 1 oder 2, wobei
die erste Führungsöffnung (321) eine sich verjüngende Form hat, die zu einem ersten Ende der ersten Führungsöffnung (321) hin, das in der Nähe von der zweiten Führungsöffnung (322) liegt, von einem zweiten Ende der ersten Führungsöffnung (321) her, von dem aus der Führungsstift (220) eingesetzt wird, schmäler wird.

4. Montageplatte (300) nach Anspruch 3, wobei
der vorrichtungsseitige Führungsaufbau der Führungsstift (220) ist, der montageplattenseitige Führungsaufbau die Führungsöffnung (320) ist, eine Unterseite der ersten Führungsöffnung (321) sich horizontal erstreckt und eine Oberseite der ersten Führungsöffnung (321) vom zweiten Ende zum ersten Ende nach unten geneigt ist.

5. Montageplatte (300) nach einem der Ansprüche 1 bis 4, wobei
die Führungsöffnung (320) mit einem Eintrittseinschränkungsabschnitt (328) versehen ist, der eine Bewegung des Führungsstifts (220) von der ersten Führungsöffnung (321) zu der zweiten Führungsöffnung (322) hin einschränkt.

6. Montageplatte (300) nach Anspruch 5, wobei
der Eintrittseinschränkungsabschnitt (328) einen Vorsprung aufweist, der in einem Verbindungsabschnitt zwischen der ersten Führungsöffnung (321) und der zweiten Führungsöffnung (322) ausgebildet ist.

7. Montageplatte (300) nach einem der Ansprüche 1 bis 6, die ferner
eine Traufplatte (310) umfasst, die derart eingerichtet ist, dass sie sich auf der Hauptplatte (302) erhebt.

## Revendications

1. Plaque de montage (300) sur laquelle un appareil (10) est monté,
la plaque de montage (300) comprenant :
une plaque principale (302) agencée en une position en regard d'une surface arrière de l'appareil (10) ;
une plaque latérale (304) agencée en une position en regard d'une surface latérale de l'appareil (10) ; et
un organe de blocage côté plaque de montage (330) disposé dans la plaque principale (302), sur lequel un organe de blocage côté appareil disposé dans la surface arrière de l'appareil (10) est bloqué, **caractérisée par**
une structure de guidage côté plaque de montage disposée dans la plaque latérale (304) et configuré pour guider l'organe de blocage côté appareil vers l'organe de blocage côté plaque de montage (330) en collaborant avec une structure de guidage côté appareil disposée dans la surface latérale de l'appareil (10) lors du montage de l'appareil (10) sur la plaque de montage (300), dans laquelle
l'une de la structure de guidage côté appareil et de la structure de guidage côté plaque de montage est une broche de guidage (220) et l'autre est un trou de guidage (320), et
le trou de guidage (320) comprend un premier trou de guidage (321) configuré pour guider l'organe de blocage côté appareil dans une direction de la plaque principale (302), et un second trou de guidage (322) configuré pour s'étendre depuis le premier trou de guidage (321) et guider l'organe de blocage côté appareil dans une direction le long de la plaque principale (302).

2. Plaque de montage (300) selon la revendication 1, dans laquelle
le premier trou de guidage (321) est formé pour s'étendre le long d'une direction perpendiculaire à la plaque principale (302), et le second trou de guidage (322) est formé pour s'étendre le long d'une direction parallèle à la plaque principale (302).

3. Plaque de montage (300) selon la revendication 1 ou 2, dans laquelle
le premier trou de guidage (321) a une forme effilée qui se rétrécit vers une première extrémité du premier trou de guidage (321) qui est près du second trou de guidage (322) depuis une seconde extrémité du premier trou de guidage (321) à partir duquel la broche de guidage (220) est insérée.

4. Plaque de montage (300) selon la revendication 3, dans laquelle
la structure de guidage côté appareil est la broche de guidage (220), la structure de guidage côté plaque de montage est le trou de guidage (321), une surface inférieure du premier trou de guidage (321) s'étend horizontalement, et une surface supérieure du premier trou de guidage (321) s'incline vers le bas depuis la seconde extrémité jusqu'à la première extrémité.

5. Plaque de montage (300) selon l'une quelconque des revendications 1 à 4, dans laquelle
le trou de guidage (320) est doté d'une portion de limitation d'entrée (328) qui restreint un déplacement de la broche de guidage (220) vers le second trou de guidage (322) depuis le premier trou de guidage (321).

6. Plaque de montage (300) selon la revendication 5, dans laquelle
la portion de limitation d'entrée (328) comporte une protubérance formée dans une portion reliée entre le premier trou de guidage (321) et le second trou de guidage (322).

7. Plaque de montage (300) selon l'une quelconque des revendications 1 à 6, comprenant en outre :
une plaque en corniche (310) configurée pour être verticale sur la plaque principale (302).
